Europäisches Patentamt

European Patent Office

Office européen des brevets

(19)

(11) Veröffentlichungsnummer : **0 022 203**
**B1**

(12)  **EUROPÄISCHE PATENTSCHRIFT**

(45) Veröffentlichungstag der Patentschrift :
09.03.83

(21) Anmeldenummer : 80103473.7

(22) Anmeldetag : 21.06.80

(51) Int. Cl.³ : **H 01 L 29/82**, H 01 L 39/22,
H 01 L 29/06

(54)  **Magnetisch steuerbarer Widerstand.**

(30) Priorität : 03.07.79 DE 2926786

(43) Veröffentlichungstag der Anmeldung :
14.01.81 Patentblatt 81/02

(45) Bekanntmachung des Hinweises auf die Patenterteilung : 09.03.83 Patentblatt 83/10

(84) Benannte Vertragsstaaten :
CH FR GB IT LI NL

(56) Entgegenhaltungen :
DE A 1 514 727
DE A 2 837 394
GB A 1 222 624
GB A 1 296 348

SOLID-STATE ELECTRONICS, Band 11, 1968
Oxford S. SCHÄFER « Herstellung von p-n-Übergängen durch gemeinsame plastische Verformung von p- und n-dotiertem Germanium », Seiten 675 bis 681.

(73) Patentinhaber : **Licentia Patent-Verwaltungs-GmbH
Theodor-Stern-Kai 1
D-6000 Frankfurt/Main 70 (DE)**

(72) Erfinder : **Dahlberg, Reinhard, Dr.
Innere Bergstrasse 32
D-7101 Flein (DE)**

(74) Vertreter : **Maute, Hans-Jürgen, Dipl.-Ing.
Licentia Patent-Verwaltungs-GmbH Theo-
dor-Stern-Kai 1
D-6000 Frankfurt/Main 70 (DE)**

## Magnetisch steuerbarer Widerstand

Die Erfindung betrifft einen elektrischen Widerstand, dessen Größe über ein Magnetfeld steuerbar ist.

Es ist bekannt, daß z. B. eine Wismut-Spirale in einem Magnetfeld von $\sim 7,96 \cdot 10^5$ A/m ($\sim 10^4$ Oersted) einen um etwa 50 % vergrößerten Widerstand aufweist. Auch Halbleiter wie z. B. InSb mit hoher Beweglichkeit der Ladungssträger zeigen in starken Magnetfeldern über die Verkleinerung der Beweglichkeit eine Zunahme ihres Widerstandes. Ganz besonders stark ist der Einfluß von Magnetfeldern auf Supraleiter. Wenn das Magnetfeld einen kritischen Wert erreicht, verschwindet die Supraleitfähigkeit. Dieser Effekt wird bei supraleitenden Schaltern ausgenutzt. Man benötigt im allgemeinen jedoch Felder in der Größenordnung von Kilo-Oersted, um merkliche Effekte zu erzeugen.

Der Erfindung liegt die Aufgabe zugrunde, einen magnetisch steuerbaren Widerstand anzugeben, der eine sehr viel größere Magnetfeld-Empfindlichkeit hat. Diese Aufgabe wird erfindungsgemäß dadurch gelöst, daß zwei getrennte Körper aus ferro- oder ferri-magnetischem Material vorgesehen sind, daß mindestens einer der Körper eine Struktur mit mindestens drei sich verjüngenden Erhebungen aufweist, daß auf mindestens einen der Körper eine Schicht eines Materials aufgebracht ist, dessen spezifischer elektrischer Widerstand sich in einem Magnetfeld ändert, daß die beiden Körper unter mechanischem Druck so zusammengesetzt sind, daß an den Berührungsstellen im Bereich der sich verjüngenden Erhebungen Druckkontakte über die Magnetfeld-empfindliche Schicht entstehen, und daß zwischen den beiden Körpern ein elektrisches und ein magnetisches Feld besteht.

Die mindestens drei sich verjüngenden Erhebungen sind im allgemeinen flächengleich. Die Dreipunkt-Auflage erzeugt mechanische Stabilität.

Eine bevorzugte Ausführungsform des magnetisch steuerbaren Widerstandes nach der Erfindung ist so ausgebildet, daß beide Körper die Form von Platten oder Scheiben haben. Auf einer ihrer beiden Oberflächene haben die Platten oder Scheiben eine Struktur mit parallel zueinander verlaufenden, sich auf einen schmalen Grat verjüngenden Wällen. Sie sind bezüglich der Wallstrukturen in der Platten- oder Scheibenebene gegeneinander verdreht und werden unter Druck mit ihren strukturierten Oberflächenseiten zusammengesetzt. Die sich kreuzenden Wälle bilden mit ihren Graten an den Berührungsstellen flächenmäßig kleine Druckkontakte auf beiden Seiten der Magnetfeld-empfindlichen Schicht. Das Prinzip der gekreuzten parallelen Wälle wird bereits in der DE-A-25 47 262 beschrieben. Die Herstellung eines magnetisch steuerbaren Widerstandes nach diesem Prinzip wird dort jedoch nicht erwähnt.

Durch die sich verjüngenden Erhebungen aus ferroelektrischem Material wird bei der Erfindung der magnetische Induktionsfluß bis zur Magnetfeld-empfindlichen Schicht verdichtet. Die Erhebungen wirken wie die kegelförmigen Polschuhe eines Magneten. Die Magnetfeld-empfindliche Schicht wirkt wie ein dünner Luftspalt zwischen den Polschuhen eines Magneten.

Wenn sich eine Erhebung aus ferroelektrischem Material aus einer Grundfläche von $1 \cdot 10^{-2} \times 1 \cdot 10^{-2}$ cm auf eine Fläche von $5 \cdot 10^{-4} \times 5 \cdot 10^{-4}$ cm verjüngt, dann werden die Magnetfeldlinien theoretisch um einen Faktor $10^3$ verdichtet. In der Praxis ist dieser Faktor wesentlich kleiner wegen der Magnetfeld-Abhängigkeit der Permeabilität des Ferromagnetikums. Es lassen sich jedoch auf diese Weise in der Magnetfeld-empfindlichen Schicht Feldstärken erzeugen, die um mehrere Größenordnungen größer sind als das äußere Magnetfeld.

Darüber hinaus hat der magnetische Widerstand nach der Erfindung den Vorteil, daß die Magnetfeld-empfindlichen Schichten extrem gut gekühlt sind. Diese Schichten befinden sich als « Fremdschichten » in einem Kontaktwiderstand. Die zulässigen Leistungsdichten $P = $ (Watt/cm$^2$) steigen bekanntlich proportional mit 1/2D', wobei 2D der Durchmesser des Kontaktes ist.

Es lassen sich deshalb nach der Erfindung mit Vorteil auch magnetisch steuerbare Widerstände für große elektrische Verlustleistungen ohne unzulässige Erwärmung der Magnetfeld-empfindlichen Schicht herstellen.

Die Platten oder Scheiben können aus einem ferro- oder ferrimagnetischem Material mit guter elektrischer Leitfähigkeit wie z. B. aus einer Eisen-Nickel-Legierung oder einer glasartigen magnetischen Metall-Legierung bestehen. Die Platten oder Scheiben können jedoch auch aus ferro- oder ferrimagnetischem Material bestehen, welches ein schlechter Leiter oder sogar ein Isolator ist, wie z. B. aus Oxydgemischen für sehr hohe Frequenzen. In diesem Fall sind die Platten oder Scheiben einschließlich der Strukturen des magnetisch steuerbaren Widerstandes nach der Erfindung mit einer Schicht eines elektrisch gut leitenden Metalles wie z. B. Ag, Cu, Al u. a. überzogen. Als Material für die Platten oder Scheiben kann mit Vorteil weiches ferro- oder ferrimagnetisches Material mit hoher Sättigungsfeldstärke verwendet werden.

Als Material für die magnetfeldabhängigen Widerstands-Schichten können Wismut, Tellur, III/V-Verbindungen oder II/VI-Verbindungen u. a. verwendet werden.

Als Material mit Magnetfeld-abhängigem Widerstand für die Schichten kann erfindungsgemäß auch supraleitendes Material verwendet werden, wobei der magnetisch steuerbare Widerstand bei tiefer Temperatur betrieben wird.

Der magnetisch steuerbare Widerstand eignet sich mit einem geeigneten magnetischen Steuerfeld zur Verstärkung von elektrischer Leistung bis zu höheren Frequenzen. Er ist auch als Oszillator über die Auswahl geeigneter ferro- oder ferrimagnetischer Materialien bis zu allerhöchsten Frequenzen ausbildbar. Auch als Schalter und als supraleitender Schalter ist er einsetzbar. Durch supraleitende Schichten auf beiden Körpern lassen sich nach der Erfindung Josephson-Punkt-Kontakt-Junctions und magnetisch steuerbare Widerstände als magnetisch gesteuerte Josephson-Bauelemente ausbilden.

Mehrere magnetisch steuerbare Widerstände können elektrisch parallel und in Serie geschaltet sein.

Die Erfindung wird im folgenden in 5 Ausführungsbeispielen näher erläutert.

Ausführungsbeispiel 1 beschreibt das Prinzip des magnetisch steuerbaren Widerstandes mit einer Wismutschicht.

Ausführungsbeispiel 2 beschreibt einen magnetisch steuerbaren Widerstand mit parallelen Wällen als Verstärker.

Ausführungsbeispiel 3 beschreibt einen Oszillator, der mit einer supraleitenden Schicht bei tiefer Temperatur arbeitet.

Ausführungsbeispiel 4 beschreibt einen supraleitenden Leistungsschalter.

Ausführungsbeispiel 5 beschreibt ein magnetisch gesteuertes Josephson-Bauelement.

Ausführungsbeispiel 1

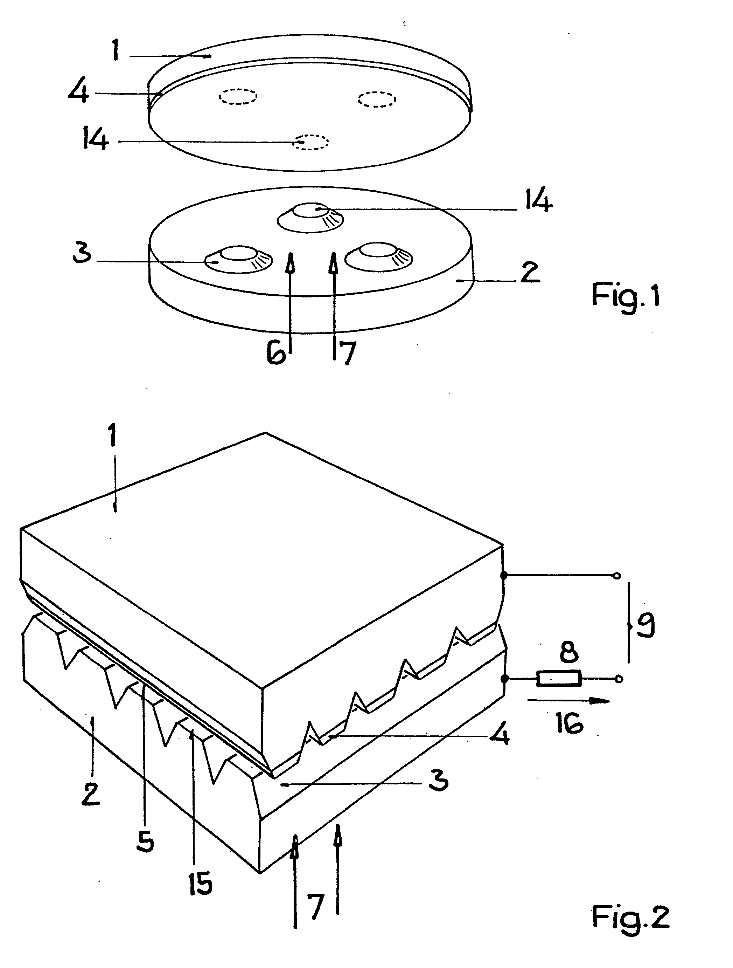

In Fig. 1 sind 1 und 2 Scheiben aus Eisen. Die Scheibe 2 trägt drei kegelstumpfartige Erhebungen 3 aus Eisen, die sich bis zu den stirnseitigen Auflageflächen 14 verjüngen. Das Flächenverhältnis von Basis zu Auflagefläche 14 dieser Erhebungen ist 100 : 1. Die Eisenscheibe 1 ist auf der Unterseite mit einer ca. $5 \cdot 10^{-3}$ cm dicken Wismutschicht 4 überzogen. Die Scheiben 1 und 2 werden unter Druck so zusammengelegt, daß die Auflageflächen 14 der Erhebungen 3 mit der Wismutschicht 4 auf der Scheibe 1 parallel geschaltete Druck-Kontakte bilden. Bei Anlegen des kleinen äußeren Magnetfeldes 7 tritt in der Wismutschicht 4 (die wie ein Luftspalt wirkt) als Folge der Permeabilität des Eisens und der Polschuh-Wirkung der Erhebungen 3 ein Magnetfeld auf, das um Größenordnungen größer ist als das äußere Magnetfeld 7. 6 ist ein elektrisches Feld.

Ausführungsbeispiel 2

In Fig. 2 sind 1 und 2 Platten aus einer weichen ferromagnetischen glasartigen Legierung mit einer Sättigungs-Induktion von 24 Kilo-Gauss. Beide Platten tragen auf einer ihrer Oberflächenseiten eine Struktur mit parallel zueinander verlaufenden, sich bis auf einen Grat 15 von $1 \cdot 10^{-3}$ cm Breite verjüngenden Wällen 3, die durch entsprechende Gräben voneinander getrennt sind. Die Scheibe 1 wurde vor der Erzeugung der Struktur aus den Wällen 3 auf der für die Wallstruktur vorgesehenen Oberflächenseite mit einer $1 \cdot 10^{-3}$ cm dicken n-InSb-Schicht 4 mit einem spezifischen Widerstand von ca. $3 \cdot 10^{-3}$ $\Omega$ cm

bedampft, die im Bereich der zwischen den Wällen liegenden Gräben bei deren Herstellung wieder entfernt wird. Durch Aufeinanderlegen der Platten 1 und 2 mit ihren strukturierten und bezüglich dieser Strukturen um 90° in der Plattenebene gegeneinander verdrehten Oberflächenseiten sind 25 Druck-Kontakte 5 mit je einer Fläche von $1 \cdot 10^{-6}$ cm$^2$ an der n-InSb-Schicht 4 entstanden. Der Gesamtwiderstand beträgt etwa 0,2 Ohm. Über den an die Platte 2 angeschlossenen Widerstand 8 wird die Gleichspannung 9 zwischen die beiden ferromagnetischen Platten 1 und 2 gelegt. Durch ein äußeres magnetisches Wechselfeld 7 von maximal ca. 1,5 Oersted entsteht in den n-InSb-Schichten 4 ein maximales magnetisches Wechselfeld von über 20 000 Oersted. Als Folge davon verändert sich mit der Schwankungsfrequenz des magnetischen Wechselfeldes 7 der elektrische Widerstand der n-InSb-Schichten, so daß der elektrische Strom 16 durch die Anordnung durch das magnetische Wechselfeld 7 moduliert wird.

Ausführungsbeispiel 3

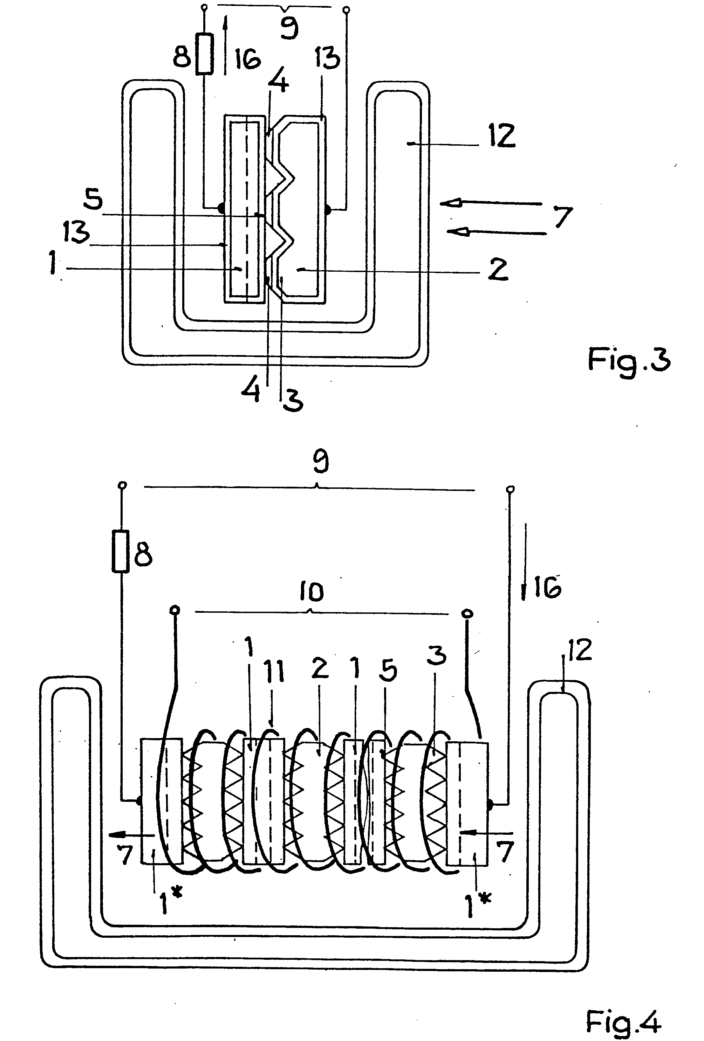

In Fig. 3 sind 1 und 2 weichmagnetische Ferrit-Scheiben mit einem spezifischen elektrischen Widerstand von ca. $10^{13}$ $\Omega$ cm. Auf beiden Scheiben ist einseitig eine Struktur aus parallel zueinander verlaufenden, sich auf einen Grat 15 (Fig. 2) von $2 \cdot 10^{-4}$ cm Breite verjüngenden Wällen 3 erzeugt worden. Danach sind beide Platten 1 und 2 mit einer Goldschicht 13 von $5 \cdot 10^{-5}$ cm Dicke überzogen worden. Auf die Grate der Platte 2 wurde über die Goldschicht 13 eine Bleischicht 4 mit einer Dicke von $1,5 \cdot 10^{-4}$ cm aufgedampft. Danach wurden beide Platten 1 und 2 unter Druck mit den strukturierten Oberflächenseiten so zusammengesetzt, daß die Walle 3 beider Platten sich kreuzen. Dadurch sind beim dargestellten Ausführungsbeispiel mit je drei Wällen 3 neun elektrisch parallel geschaltete Kontakte 5 mit einer Fläche von je $4 \cdot 10^{-8}$ cm$^2$ an der Bleischicht 4 entstanden. Über den Vorwiderstand 8 an der Platte 1 ist die Gleichspannungsquelle 9 mit ihren Polen an die Goldschichten 13 der beiden Platten 1 und 2 angeschlossen, die sich im Tiefkühl-Gefäß 12 auf der Temperatur des flüssigen Heliums befinden. Die Bleischichten 4 sind supraleitend, so daß ein Strom fließt, welcher durch den Vorwiderstand 8 von $4 \cdot 10^{-2}$ Ohm begrenzt wird. Durch ein sinusförmiges magnetisches Wechselfeld 7 wird die kritische magnetische Feldstärke in den Bleischichten 4 während jeder Halbwelle einmal über- und einmal unterschritten. Als Folge davon fließen rechteckförmige Stromimpulse 16 durch den Widerstand 8.

Ausführungsbeispiel 4

In Fig. 4 sind 1 und 2 Eisenplatten von $2,5 \cdot 10^{-2}$ cm Dicke, welche auf ihren beiden Oberflächenseiten eine Struktur mit parallelen Wällen 3 tragen, die sich auf Grate mit einer Breite

von ca. $1 \cdot 10^{-4}$ cm verjüngen. Die Endplatten 1* sind nur einseitig, nämlich auf der nach innen gewandten Oberflächenseite, mit einer Wallstruktur versehen. Die Eisenplatten 1, 1* und 2 sind vollständig mit einer nicht dargestellten Zinnschicht von $1 \cdot 10^{-4}$ cm Dicke überzogen und so unter Druck zusammengesetzt, daß sich die Wälle auf den beiden einander zu gewandten Oberflächenseiten zweier benachbarter Platten jeweils kreuzen. Jeder Übergang von einer Platte 1 zu einer Platte 2 wird durch 25 Zinn-Kontakte 5 mit einer Fläche von je $1 \cdot 10^{-8}$ cm$^2$ gebildet. Es werden beispielsweise 400 Platten 1 abwechselnd mit 400 Platten 2 zusammengesetzt und unter Druck fixiert. Die Kaskade von Platten 1 und 2 hat dann einen elektrischen Widerstand von etwa 6 Ohm, der verschwindet, wenn sich die Kaskade in dem Tiefkühlgefäß 12 auf der Temperatur des flüssigen Heliums befindet. Über den an eine Außenplatte 1* angeschlossenen Widerstand 8 von $5 \cdot 10^{-4}$ Ohm wird eine Gleichspannung 9 von 2,1 Volt der Kaskade zugeführt. Die Magnetspule, die die Kaskade umgibt, kann über die Steuerspannungsquelle 10 erregt werden.

Das Magnetfeld 7 wird in den Zinnkontakten, die wie « Luftspalte » wirken, so verstärkt, daß die kritische magnetische Feldstärke des Zinns überschritten wird. Dadurch läßt sich der die Kaskade durchfließende Strom 16 von ca. 350 mA bei bestehendem Magnetfeld 7 auf 4,2 Kilo-Ampere ohne Magnetfeld 7 bzw. umgekehrt schalten.

Ausführungsbeispiel 5

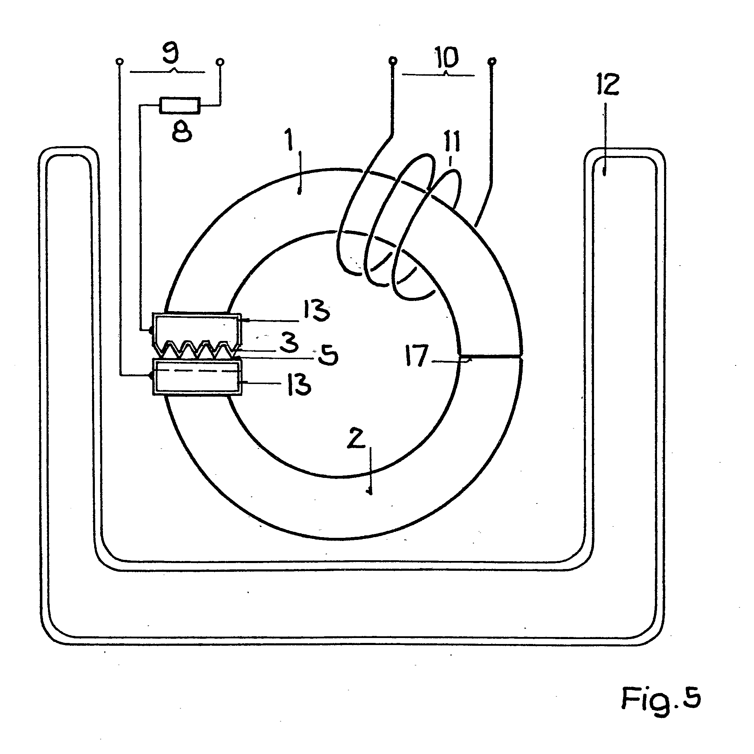

In Fig. 5 sind 1 und 2 zwei Halb-Ringe aus Hochfrequenz-Ferrit-Material. Die beiden Halbringe 1 und 2 haben je eine glatte Trennfläche 17 und je eine Trennfläche, die eine Struktur mit parallel zueinander verlaufenden Wällen 3 hat. Die Wälle 3 verjüngen sich bis auf Krümmungsradien von $5 \cdot 10^{-5}$ cm. Die Wälle 3 auf dem Halb-Ring 1 sind im zusammengesetzten Zustand der Halbringe zu einem Gesamtring in der Berührungsebene um 90° gegenüber den Wällen 3 auf dem Halb-Ring 2 gedreht. Die Strukturen mit den Wällen 3 wurden wie in Fig. 5 angedeutet mit einer $2 \cdot 10^{-5}$ cm dicken Goldschicht 13 überzogen. Auf die Wälle 3 in beiden Halb-Ringen 1 und 2 wurde über die Goldschicht 13 je eine $5 \cdot 10^{-5}$ cm dicke nicht dargestellte Niob-Nitrid-Schicht als Supraleiter in an sich bekannter Weise aufgebracht. Beide Halb-Ringe 1 und 2 wurden danach so zusammengesetzt, daß die sich überkreuzenden Wälle 3 insgesamt fünfundzwanzig elektrisch parallel geschaltete Josephson-Punktkontakt-Junctions 5 bilden. Der aus Halb-Ringen 1 und 2 zusammengesetzte Ring befindet sich im Tiefkühl-Gefäß 12 auf der Temperatur des flüssigen Heliums. Zwischen die Goldschichten 13 auf den beiden Wallstrukturen und damit an die Josephson-Junctions 5 wird über den Vorwiderstand 8 die Gleichspannung 9 angelegt. Die magnetische Steuerung der Josephson-Junctions 5 erfolgt im geschlossenen magnetischen Kreis der beiden zusammengesetzten Halb-Ringe 1 und 2 über die den Ring umschließende Spule 11 und die an die Spule anlegbare Steuerspannung 10.

Bezugsziffern

1, 1* Platte oder Scheibe
2 Platte oder Scheibe
3 Erhebungen
4 Schicht mit Magnetfeld-abhängigem Widers
5 Druck-Kontakt
6 elektrisches Feld
7 magnetisches Feld
8 elektrischer Widerstand
9 elektrische Spannung
10 elektrische Steuerspannung
11 Magnetspule
12 Tiefkühl-Gefäß
13 Metallschicht
14 Auflage-Fläche
15 Grat eines Walls
16 elektrischer Strom

**Ansprüche**

1. Magnetisch steuerbarer Widerstand dadurch gekennzeichnet, daß zwei getrennte Körper (1, 2) aus ferro- oder ferrimagnetischem Material vorgesehen sind, daß mindestens einer der Körper eine Struktur mit mindestens drei sich verjüngenden Erhebungen (3) aufweist, daß auf mindestens einen der Körper eine Schicht (4) eines Materials aufgebracht ist, dessen spezifischer elektrischer Widerstand sich in einem Magnetfeld (7) ändert, daß die beiden Körper (1, 2) unter mechanischem Druck so zusammengesetzt sind, daß an den Berührungsstellen im Bereich der sich verjüngenden Erhebungen (3) Druckkontakte (5) über die Magnetfeld-empfindliche Schicht (4) entstehen, und daß zwischen den beiden Körpern (1, 2) ein elektrisches (6) und magnetisches Feld (7) besteht.

2. Magnetisch steuerbarer Widerstand nach Anspruch 1, dadurch gekennzeichnet, daß die beiden Körper (1, 2) die Form von Platten oder Scheiben (1, 2) haben, daß beide Platten oder Scheiben (1, 2) auf einer ihrer beiden Oberflächen eine Struktur mit parallel zueinander verlaufenden, sich auf einen schmalen Grat verjüngenden Wällen (3) aufweisen, daß die bezüglich der Wallstrukturen gegeneinander verdrehten Platten oder Scheiben unter Druck mit ihren strukturierten Oberflächenseiten so zusammengesetzt sind, daß die Wälle (3) auf beiden Oberflächenseiten sich kreuzen und mit ihren Graten (12) an den Berührungsstellen flächenmäßig kleine Druckkontakte (5) auf beiden Seiten der Magnetfeld-empfindlichen Schicht (4) bilden, deren elektrischer Widerstand im Magnetfeld (7) veränderbar ist.

3. Magnetisch steuerbarer Widerstand nach Anspruch 1, dadurch gekennzeichnet, daß die beiden Körper (1, 2) die Form von Halb-Ringen haben, die zu einem geschlossenen Ring zusammensetzbar sind, daß jeder der Halb-Ringe (1, 2) mindestens auf einer Trennfläche eine Struktur paralleler, sich verjüngender Wälle (3) aufweist, und daß beim Zusammensetzen der Halb-Ringe (1, 2) die strukturierten Trennflächen beider Halbringe einander berühren, wobei sich die Wälle (3) kreuzen und an den Berührungsstellen elektrisch parallel geschaltete Druckkontakte (5) auf beiden Seiten der auf die Strukturen aufgebrachten Magnetfeld-empfindlichen Schicht (4) bilden.

4. Magnetisch steuerbarer Widerstand nach einem der Ansprüche 1 bis 3, dadurch gekennzeichnet, daß die beiden Körper (1, 2) aus einem ferro- oder ferrimagnetischen Material mit guter elektrischer Leitfähigkeit bestehen.

5. Magnetisch steuerbarer Widerstand nach einem der Ansprüche 1 bis 3, dadurch gekennzeichnet, daß die beiden Körper (1, 2) aus ferro- oder ferri-magnetischem Material bestehen, welches ein schlechter elektrischer Leiter oder ein Isolator ist, und daß die Oberflächen der Platten oder Scheiben (1, 2) sowie deren Strukturen mit einer Metallschicht (13) überzogen sind.

6. Magnetisch steuerbarer Widerstand nach einem der vorhergehenden Ansprüche, dadurch gekennzeichnet, daß die beiden Körper (1, 2) aus weichem ferro- oder ferri-magnetischem Material mit hoher Sättigungsfeldstärke bestehen.

7. Magnetisch steuerbarer Widerstand nach einem der vorhergehenden Ansprüche, dadurch gekennzeichnet, daß die Magnetfeld-empfindliche Widerstandsschichten (4) aus Wismut, Tellur, III/V-Verbindungen, II/VI-Verbindungen und anderen bestehen.

8. Magnetisch steuerbarer Widerstand nach einem der Ansprüche 1 bis 6, dadurch gekennzeichnet, daß die Magnetfeld-empfindlichen Widerstandsschichten (4) aus supraleitendem Material bestehen.

9. Magnetisch steuerbarer Widerstand nach Anspruch 8, dadurch gekennzeichnet, daß die beiden Körper (1, 2) mit einer supraleitenden Schicht (4) mindestens teilweise überzogen sind, und daß die Druckkontakte (5) zwischen den supraleitenden Schichten (4) Josephson-Punktkontakt-Junctions bilden.

10. Magnetisch steuerbarer Widerstand nach einem der vorhergehenden Ansprüche, gekennzeichnet durch seine Verwendung bei tiefen Temperaturen.

11. Magnetisch steuerbarer Widerstand nach einem der vorhergehenden Ansprüche, gekennzeichnet durch seine Verwendung als Verstärker von elektrischer Leistung.

12. Magnetisch steuerbarer Widerstand nach einem der vorhergehenden Ansprüche, gekennzeichnet durch seine Verwendung als magnetischer Schalter.

13. Magnetisch steuerbarer Widerstand nach einem der vorhergehenden Ansprüche, gekennzeichnet durch seine Verwendung als Oszillator.

14. Magnetisch steuerbarer Widerstand nach einem der vorhergehenden Ansprüche, gekennzeichnet durch seine Verwendung als magnetisch gesteuertes Josephson-Bauelement.

Claims

1. Magnetically controllable resistor characterized in that two separate bodies (1, 2) made of ferromagnetic or ferrimagnetic material are provided, in that at least one of the bodies comprises a structure with at least three tapering elevations (3), in that there is provided on at least one of the bodies a layer (4) consisting of a material whose specific electric resistance alters in a magnetic field (7), in that the two bodies (1, 2) are combined under mechanical pressure so as to produce at the points of contact in the vicinity of the tapering elevations (3) pressure contacts (5) over the layer (4) responsive to the magnetic field, and in that an electric field (6) and a magnetic field (7) are present between the two bodies (1, 2).

2. Magnetically controllable resistor as defined in claim 1, characterized in that the two bodies (1, 2) are in the form of plates or discs (1, 2), in that the two plates or discs (1, 2) comprise on one of their two surfaces a structure with walls (3) extending parallel to one another and tapering to a narrow ridge, in that the plates or discs which are offset with respect to the wall structures are combined under pressure with their structured surface sides such that the walls (3) cross on both side surfaces and form with their ridges (12) at the points of contact, surface-wise, small pressure contacts (5) on both sides of the layer (4) which is responsive to the magnetic field and whose electric resistance is alterable in the magnetic field (7).

3. Magnetically controllable resistor as defined in claim 1, characterized in that the two bodies (1, 2) are in the form of half-rings which are combinable to form a closed ring, in that each of the half-rings (1, 2) comprises at least on one separation surface a structure of parallel, tapering walls (3), and in that when the half-rings (1, 2) are combined, the structured separation surfaces of both half-rings come into contact with each other, with the walls (3) crossing and electrically parallel connected pressure contacts (5) being formed at the points of contact on both sides of the layer (4) which is provided on the structures and is responsive to the magnetic field.

4. Magnetically controllable resistor as defined in one of claims 1 to 3, characterized in that the two bodies (1, 2) consist of ferromagnetic or ferrimagnetic material with good electric conductivity.

5. Magnetically controllable resistor as defined in one of claims 1 to 3, characterized in that the two bodies (1, 2) consist of ferromagnetic or ferrimagnetic material which is a poor electric conductor or an insulator, and in that the surfaces of the plates or discs (1, 2) and their structures are coated with a metal layer (13).

6. Magnetically controllable resistor as defined in one of the preceding claims, characterized in that the two bodies (1, 2) consist of soft ferromagnetic material or ferrimagnetic material with high saturation field strength.

7. Magnetically controllable resistor as defined in one of the preceding claims, characterized in that the resistor layers (4) which are responsive to the magnetic field consist of bismuth, tellurium, III/V compounds, II/VI compounds and others.

8. Magnetically controllable resistor as defined in one of claims 1 to 6, characterized in that the resistor layers (4) which are responsive to the magnetic field consist of superconducting material.

9. Magnetically controllable resistor as defined in claim 8, characterized in that the two bodies (1, 2) are coated at least partially with a superconducting layer (4), and in that the pressure contacts (5) between the superconducting layers (4) form Josephson point-contact junctions.

10. Magnetically controllable resistor as defined in one of the preceding claims, characterized by its use at low temperatures.

11. Magnetically controllable resistor as defined in one of the preceding claims, characterized by its use as an amplifier of electric power.

12. Magnetically controllable resistor as defined in one of the preceding claims, characterized by its use as a magnetic switch.

13. Magnetically controllable resistor as defined in one of the preceding claims, characterized by its use as an oscillator.

14. Magnetically controllable resistor as defined in one of the preceding claims, characterized by its use as a magnetically controlled Josephson component.


**Revendications**

1. Résistance à commande magnétique, caractérisée en ce que deux corps séparés (1, 2) en matériau ferromagnétique ou ferrimagnétique sont prévus ; un des corps au moins présente une structure avec trois bossages (3) coniques au minimum ; une couche (4) d'un matériau dont la résistivité varie dans un champ magnétique (7) est déposée sur un des corps au moins ; les deux corps (1, 2) sont assemblés sous pression mécanique, de façon à produire aux points de contact, dans la zone des bossages coniques (3), des contacts par pression (5) sur la couche (4) sensible au champ magnétique ; et un champ électrique (6) et magnétique (7) règne entre les deux corps (1, 2).

2. Résistance à commande magnétique selon revendication 1, caractérisée en ce que les deux corps (1, 2) ont la forme de plaquettes ou de disques (1, 2) ; les deux plaquettes ou disques (1, 2) présentent sur une de leurs deux surfaces une structure de protubérances (3) parallèles et se rétrécissant pour former une crête étroite ; les plaquettes ou disques sont décalés par rapport aux structures de protubérances, puis assemblés sous pression par leurs faces superficielles structurées, de façon que les protubérances (3) se croisent sur les deux faces superficielles et forment par leurs crêtes (12), aux points de contact, des contacts par pression de faible surface sur les deux côtés de la couche (4) sensible au champ magnétique, dont la résistance électrique est variable dans le champ magnétique (7).

3. Résistance à commande magnétique selon revendication 1, caractérisée en ce que les deux corps (1, 2) ont la forme de demi-anneaux, assemblables en un anneau fermé ; chacun des demi-anneaux (1, 2) présente sur une face de séparation au moins une structure de protubérances (3) parallèles et coniques ; et lors de l'assemblage des demi-anneaux (1, 2), les faces de séparation structurées des deux demi-anneaux viennent en contact, les protubérances (3) se croisant et formant, aux points de contact, des contacts par pression (5) couplés électriquement en parallèle sur les deux côtés de la couche (4) sensible au champ magnétique et déposée sur les structures.

4. Résistance à commande magnétique selon une quelconque des revendications 1 à 3, caractérisée en ce que les deux corps (1, 2) sont réalisés dans un matériau ferromagnétique ou ferrimagnétique à bonne conductibilité électrique.

5. Résistance à commande magnétique selon une quelconque des revendications 1 à 3, caractérisée en ce que les deux corps (1, 2) sont réalisés dans un matériau ferromagnétique ou ferrimagnétique, mauvais conducteur électrique ou isolant ; et les surfaces des plaquettes ou disques (1, 2) et leurs structures sont recouvertes d'une couche métallique (13).

6. Résistance à commande magnétique selon une quelconque des revendications 1 à 5, caractérisée en ce que les deux corps (1, 2) sont réalisés dans un matériau ferromagnétique ou ferrimagnétique à champ de saturation élevé.

7. Résistance à commande magnétique selon une quelconque des revendications 1 à 6, caractérisée en ce que les couches (4) à résistance sensible au champ magnétique sont en bismuth, tellure, composés III/V, composés II/VI ou autres.

8. Résistance à commande magnétique selon une quelconque des revendications 1 à 6, caractérisée en ce que les couches (4) à résistance sensible au champ magnétique sont réalisées dans un matériau supraconducteur.

9. Résistance à commande magnétique selon revendication 8, caractérisée en ce que les deux corps (1, 2) sont recouverts au moins partiellement d'une couche supraconductrice (4) ; et les contacts par pression (5) entre les couches supraconductrices (4) forment des jonctions à contact ponctuel de Josephson.

10. Résistance à commande magnétique selon une quelconque des revendications 1 à 9, caractérisée par son utilisation aux basses températures.

11. Résistance à commande magnétique selon une quelconque des revendications 1 à 10, caractérisée par son utilisation comme amplificateur de puissance électrique.

12. Résistance à commande magnétique selon une quelconque des revendications 1 à 11, caractérisée par son utilisation en interrupteur magnétique.

13. Résistance à commande magnétique selon une quelconque des revendications 1 à 12, caractérisée par son utilisation en oscillateur.

14. Résistance à commande magnétique selon une quelconque des revendications 1 à 13, caractérisée par son utilisation en composant de Josephson à commande magnétique.

Fig.1

Fig.2

Fig.3

Fig.4

Fig.5